# EUROPEAN PATENT APPLICATION

(11) **EP 4 622 397 A1**
(43) Date of publication of application: **24.09.2025**
(21) Application number: 23897586.6
(22) Date of filing: 20.11.2023
(51) Int. Cl.: H05H 1/46

(54) **PLASMA PROCESSING DEVICE, POWER SUPPLY SYSTEM, AND FREQUENCY CONTROL METHOD**

(30) Priority: 30.11.2022 JP 2022191299
(71) Applicant: Tokyo Electron Limited, Tokyo 107-6325 (JP)
(72) Inventor: KOSHIMIZU, Chishio, Kurokawa-gun, Miyagi 981-3629 (JP)
(74) Representative: Hoffmann Eitle
(86) International application number: PCT/JP2023/041648
(87) International publication number: WO 2024/116938

(57) **Abstract**

In a disclosed plasma processing apparatus, a radio frequency power supply determines a first temporal change pattern of a source frequency of the source radio frequency power which most suppresses degree of reflection of the source radio frequency power, while changing the source frequencies of first time points in a waveform cycle of an electric bias and interpolating the source frequency in each of first division periods in the waveform cycle divided by the first time points. The radio frequency power supply determines a second temporal change pattern of the source frequency which most suppresses degree of reflection of the source radio frequency power, while changing the source frequencies of second time points in the waveform cycle from the first temporal change pattern or the derived pattern and interpolating the source frequency in each of second division periods in the waveform cycle by the second time points.

## Description

### Technical Field

Example embodiments of the present disclosure relate to a plasma processing apparatus, a power supply system, and a frequency control method.

### Background Art

A plasma processing apparatus is used in plasma processing to be performed on a substrate. The plasma processing apparatus generates plasma from a gas in a chamber by supplying a source radio frequency power. The plasma processing apparatus uses a bias radio frequency power to attract ions from the plasma generated in the chamber onto the substrate. Patent Literature 1 discloses a plasma processing apparatus that modulates a power level and a frequency of a bias radio frequency power.

### Citation List

### Patent Literature

Patent Literature 1 : Japanese Unexamined Patent Application Publication No. 2009-246091

### Summary of Invention

### Technical Problem

The present disclosure provides a technology to reduce a degree of reflection of source radio frequency power.

### Solution to Problem

A plasma processing apparatus is provided in an example embodiment. The plasma processing apparatus includes a chamber, a substrate support, a radio frequency power supply, and a bias power supply. The substrate support is disposed in the chamber. The radio frequency power supply is configured to supply a source radio frequency power to generate plasma from a gas in the chamber. The bias power supply is configured to supply an electric bias having a waveform cycle to the substrate support. The radio frequency power supply is configured to determine a first temporal change pattern of a source frequency of the source radio frequency power in the waveform cycle which most suppresses a degree of reflection of the source radio frequency power. The radio frequency power supply determines the first temporal change pattern by using respective source frequencies of the source radio frequency power at a plurality of first time points in the waveform cycle and an interpolated source frequency in each of a plurality of first division periods, while changing the respective source frequency at the plurality of first time points. The plurality of first division periods are divided by the plurality of first time points. The radio frequency power supply is configured to determine a second temporal change pattern of the source frequency in the waveform cycle which most suppresses a degree of reflection of the source radio frequency power. The radio frequency power supply determines the second temporal change pattern by using the respective source frequencies of the source radio frequency power at a plurality of second time points in the waveform cycle and an interpolated source frequency in each of a plurality of second division periods, while changing the respective source frequency at the plurality of second time points based on the first temporal change pattern or a temporal change pattern of the source frequency generated from the first temporal change pattern. The plurality of second division periods are divided by the plurality of second time points. A number of the plurality of second division periods is greater than a number of the plurality of first division periods.

### Advantageous Effects of Invention

According to the example embodiment, it is possible to reduce a degree of reflection of source radio frequency power.

### Brief Description of Drawings

FIG. 1 is a diagram for illustrating a configuration example of a plasma processing system.
FIG. 2 is a diagram for illustrating a configuration example of a capacitively coupled plasma processing apparatus.
FIG. 3 is a diagram illustrating a configuration example of a power supply system in a plasma processing apparatus according to one example embodiment.
Each of (a) of FIG. 4 and (b) of FIG. 4 is a diagram illustrating an example of the waveform of an electric bias.
FIG. 5 is a diagram for describing an example of an optimization process of a temporal change pattern of a source frequency.
FIG. 6 is a diagram for describing an example of an optimization process of a temporal change pattern of a source frequency.
FIG. 7 is a diagram for describing an example of an optimization process of a temporal change pattern of a source frequency.
FIG. 8 is a diagram for describing an example of an optimization process of a temporal change pattern of a source frequency.
Each of (a) of FIG. 9 and (b) of FIG. 9 is a timing chart of an example of a source radio frequency power and an electric bias.
Each of (a) of FIG. 10 and (b) of FIG. 10 is a timing chart of an example of a source radio frequency power and an electric bias.
Each of (a) of FIG. 11 to (c) of FIG. 11 is a timing chart of an example of electric bias.

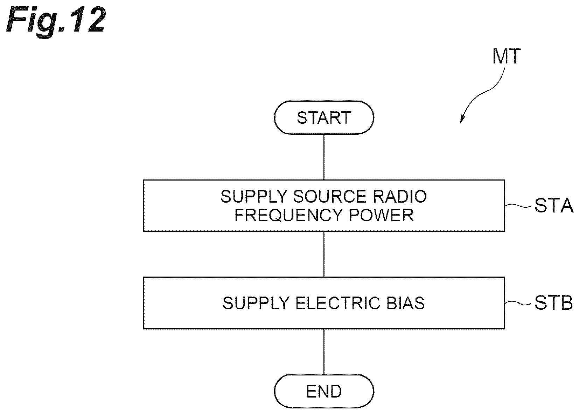

FIG. 12 is a flowchart illustrating a frequency control method according to one example embodiment.

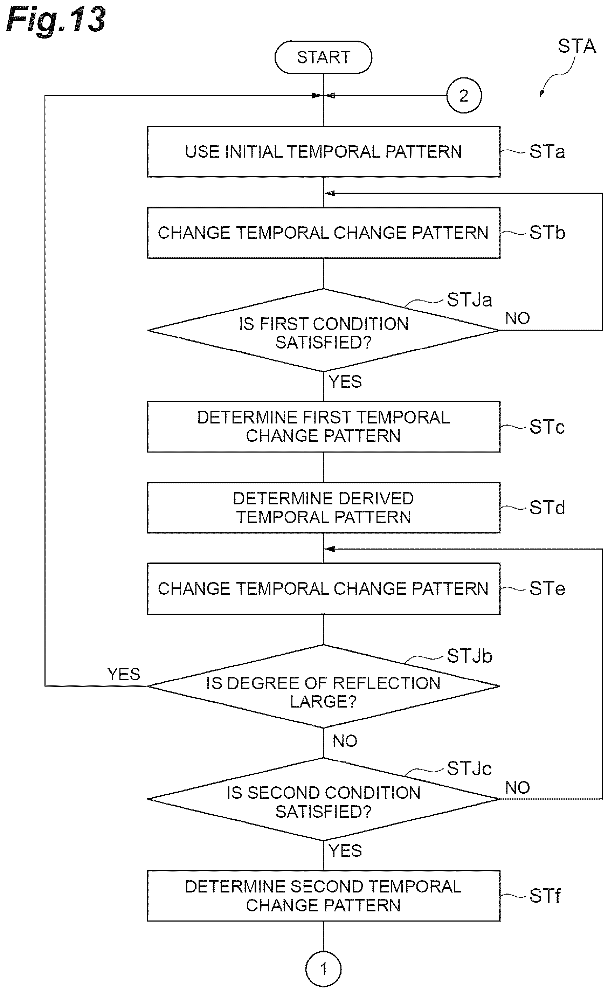

FIG. 13 is a flowchart illustrating an example of step STA of a frequency control method according to one example embodiment.

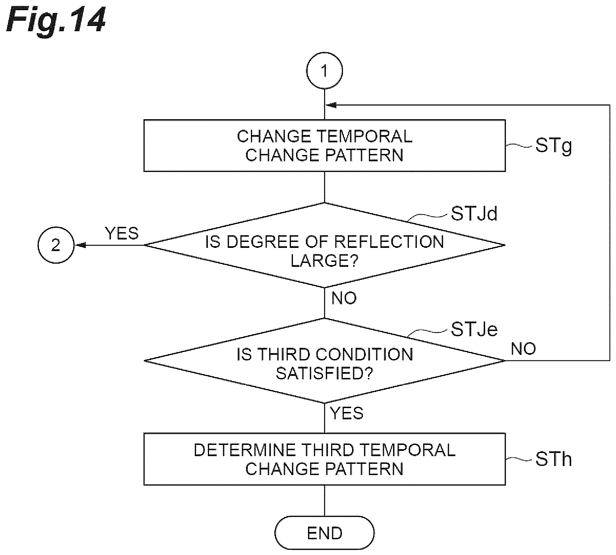

FIG. 14 is a flowchart illustrating an example of step STA of a frequency control method according to one example embodiment.

### Description of Embodiments

Hereinafter, various example embodiments will be described in detail with reference to the drawings. In the drawings, the same or equivalent portions are denoted by the same reference symbols.

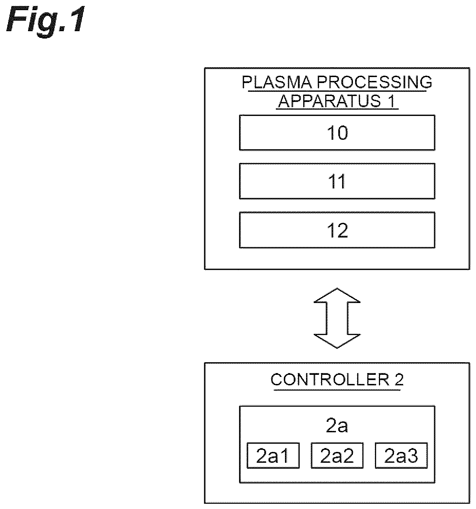

Fig. 1 illustrates an example configuration of a plasma processing system. In an embodiment, the plasma processing system includes a plasma processing apparatus 1 and a controller 2. The plasma processing system is an example substrate processing system, and the plasma processing apparatus 1 is an example substrate processing apparatus. The plasma processing apparatus 1 includes a plasma processing chamber 10, a substrate support 11, and a plasma generator 12. The plasma processing chamber 10 has a plasma processing space. The plasma processing chamber 10 further has at least one gas inlet for supplying at least one process gas into the plasma processing space and at least one gas outlet for exhausting gases from the plasma processing space. The gas inlet is connected to a gas supply 20 described below and the gas outlet is connected to a gas exhaust system 40 described below. The substrate support 11 is disposed in a plasma processing space and has a substrate support surface for supporting a substrate.

The plasma generator 12 is configured to generate a plasma from the at least one process gas supplied into the plasma processing space. The plasma formed in the plasma processing space may be, for example, a capacitively coupled plasma (CCP), an inductively coupled plasma (ICP), an electron-cyclotron-resonance (ECR) plasma, a helicon wave plasma (HWP), or a surface wave plasma (SWP).

The controller 2 processes computer executable instructions causing the plasma processing apparatus 1 to perform various steps described in this disclosure. The controller 2 may be configured to control individual components of the plasma processing apparatus 1 such that these components execute the various steps described herein. In an embodiment, the functions of the controller 2 may be partially or entirely incorporated into the plasma processing apparatus 1. The controller 2 may include a processor 2a1, a storage 2a2, and a communication interface 2a3. The controller 2 is implemented in, for example, a computer 2a. The processor 2a1 may be configured to read a program from the storage 2a2, and then perform various controlling operations by executing the program. This program may be preliminarily stored in the storage 2a2 or retrieved from any medium, as appropriate. The resulting program is stored in the storage 2a2, and then the processor 2a1 reads to execute the program from the storage 2a2. The medium may be of any type which can be accessed by the computer 2a or may be a communication line connected to the communication interface 2a3. The processor 2a1 may be a central processing unit (CPU) or a programmable logic device such as a FPGA (Field-Programmable Gate Array). The storage 2a2 may include a random access memory (RAM), a read only memory (ROM), a hard disk drive (HDD), a solid state drive (SSD), or any combination thereof. The communication interface 2a3 can communicate with the plasma processing apparatus 1 via a communication line, such as a local area network (LAN).

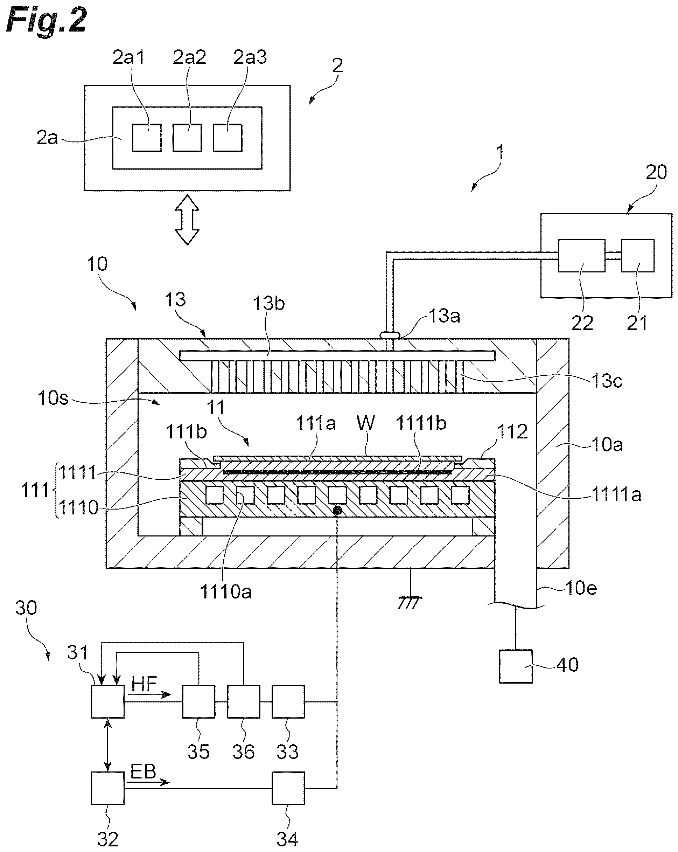

An example configuration of a capacitively coupled plasma processing apparatus, which is an example of the plasma processing apparatus 1, will now be described. Fig. 2 illustrates the example configuration of the capacitively coupled plasma processing apparatus.

The capacitively coupled plasma processing apparatus 1 includes a plasma processing chamber 10, a gas supply 20, a power supply system 30, and a gas exhaust system 40. The plasma processing apparatus 1 further includes a substrate support 11 and a gas introduction unit. The gas introduction unit is configured to introduce at least one process gas into the plasma processing chamber 10. The gas introduction unit includes a showerhead 13. The substrate support 11 is disposed in a plasma processing chamber 10. The showerhead 13 is disposed above the substrate support 11. In an embodiment, the showerhead 13 functions as at least part of the ceiling of the plasma processing chamber 10. The plasma processing chamber 10 has a plasma processing space 10s that is defined by the showerhead 13, the sidewall 10a of the plasma processing chamber 10, and the substrate support 11. The plasma processing chamber 10 is grounded. The showerhead 13 and the substrate support 11 are electrically insulated from the housing of the plasma processing chamber 10.

The substrate support 11 includes a body 111 and a ring assembly 112. The body 111 has a central region 111a for supporting a substrate W and an annular region 111b for supporting the ring assembly 112. An example of the substrate W is a wafer. The annular region 111b of the body 111 surrounds the central region 111a of the body 111 in plan view. The substrate W is disposed on the central region 111a of the body 111, and the ring assembly 112 is disposed on the annular region 111b of the body 111 so as to surround the substrate W on the central region 111a of the body 111. Thus, the central region 111a is also called a substrate support surface for supporting the substrate W, while the annular region 111b is also called a ring support surface for supporting the ring assembly 112.

In an embodiment, the body 111 includes a base 1110 and an electrostatic chuck 1111. The base 1110 includes a conductive member. The electrostatic chuck 1111 is disposed on the base 1110. The electrostatic chuck 1111 includes a ceramic member 1111a and an electrostatic electrode 1111b disposed in the ceramic member 1111a. The ceramic member 1111a has the central region 111a. In an embodiment, the ceramic member 1111a also has the annular region 111b. Any other member, such as an annular electrostatic chuck or an annular insulting member, surrounding the electrostatic chuck 1111 may have the annular region 111b. In this case, the ring assembly 112 may be disposed on either the annular electrostatic chuck or the annular insulating member, or both the electrostatic chuck 1111 and the annular insulating member.

The ring assembly 112 includes one or more annular members. In an embodiment, the annular members include one or more edge rings and at least one cover ring. The edge ring is composed of a conductive or insulating material, whereas the cover ring is composed of an insulating material.

The substrate support 11 may also include a temperature adjusting module that is configured to adjust at least one of the electrostatic chuck 1111, the ring assembly 112, and the substrate to a target temperature. The temperature adjusting module may be a heater, a heat transfer medium, a flow passage 1110a, or any combination thereof. A heat transfer fluid, such as brine or gas, flows into the flow passage 1110a. In an embodiment, the flow passage 1110a is formed in the base 1110, one or more heaters are disposed in the ceramic member 1111a of the electrostatic chuck 1111. The substrate support 11 may further include a heat transfer gas supply configured to supply a heat transfer gas to a gap between the rear surface of the substrate W and the central region 111a.

The showerhead 13 is configured to introduce at least one process gas from the gas supply 20 into the plasma processing space 10s. The showerhead 13 has at least one gas inlet 13a, at least one gas diffusing space 13b, and a plurality of gas feeding ports 13c. The process gas supplied to the gas inlet 13a passes through the gas diffusing space 13b and is then introduced into the plasma processing space 10s from the gas feeding ports 13c. The showerhead 13 further includes at least one upper electrode. The gas introduction unit may include one or more side gas injectors provided at one or more openings formed in the sidewall 10a, in addition to the showerhead 13.

The gas supply 20 may include at least one gas source 21 and at least one flow controller 22. In an embodiment, the gas supply 20 is configured to supply at least one process gas from the corresponding gas source 21 through the corresponding flow controller 22 into the showerhead 13. Each flow controller 22 may be, for example, a mass flow controller or a pressure-controlled flow controller. The gas supply 20 may include a flow modulation device that can modulate or pulse the

The gas exhaust system 40 may be connected to, for example, a gas outlet 10e provided in the bottom wall of the plasma processing chamber 10. The gas exhaust system 40 may include a pressure regulation valve and a vacuum pump. The pressure regulation valve enables the pressure in the plasma processing space 10s to be adjusted. The vacuum pump may be a turbo-molecular pump, a dry pump, or a combination thereof.

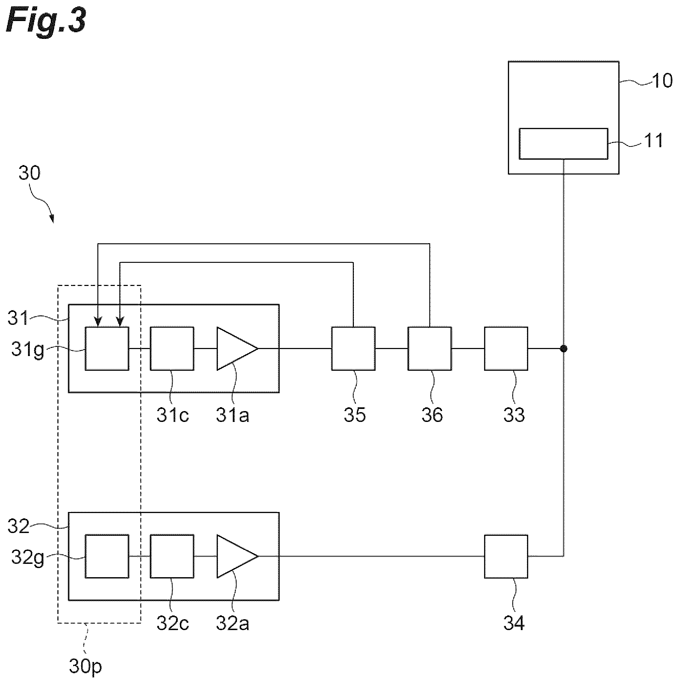

Hereinafter, reference is made to FIG. 3 together with FIG. 2. FIG. 3 is a diagram illustrating a configuration example of a power supply system in the plasma processing apparatus according to one example embodiment. A power supply system 30 includes a radio frequency power supply 31 and a bias power supply 32. The radio frequency power supply 31 configures a plasma generator 12 according to an embodiment. The radio frequency power supply 31 is configured to generate a source radio frequency power HF. The source radio frequency power HF has a source frequency f_{S}. That is, the source radio frequency power HF has a sinusoidal waveform having a frequency of a source frequency f_{S}. The source frequency f_{S} may be a frequency in a range of 10 MHz to 150 MHz.

The radio frequency power supply 31 is electrically connected to a radio frequency electrode via a matcher 33, and is configured to supply the source radio frequency power HF to the radio frequency electrode. The radio frequency electrode may be disposed in a substrate support 11. The radio frequency electrode may be at least one electrode provided in a conductive member of a base 1110 or a ceramic member 1111a. Alternatively, the radio frequency electrode may be an upper electrode. When the source radio frequency power HF is supplied to the radio frequency electrode, a plasma is generated from a gas in a chamber 10.

The matcher 33 has variable impedance. The variable impedance of the matcher 33 is set to reduce the reflection from the load of the source radio frequency power HF. The matcher 33 may be controlled by, for example, a controller 2.

In one embodiment, the radio frequency power supply 31 may include a signal generator 31g, a D/A converter 31c, and an amplifier 31a. The signal generator 31g generates a radio frequency signal having a source frequency f_{S}. The signal generator 31g may be configured by a programmable processor or a programmable logic device such as a Field-Programmable Gate Array (FPGA). The signal generator 31g may be configured by a single programmable device 30p together with a signal generator 32g described below, or may be configured with a programmable device separate from the signal generator 32g.

An output of the signal generator 31g is connected to an input of the D/A converter 31c. The D/A converter 31c converts the radio frequency signal from the signal generator 31g into an analog signal. An output of the D/A converter 31c is connected to an input of the amplifier 31a. The amplifier 31a amplifies the analog signal from the D/A converter 31c to generate the source radio frequency power HF. The amplification factor of the amplifier 31a is designated from the controller 2 to the radio frequency power supply 31. The radio frequency power supply 31 may not include the D/A converter 31c. In this case, the output of the signal generator 31g is connected to the input of the amplifier 31a, and the amplifier 31a amplifies the radio frequency signal from the signal generator 31g to generate the source radio frequency power HF.

The bias power supply 32 is electrically coupled to the substrate support 11. The bias power supply 32 is electrically connected to a bias electrode in the substrate support 11, and is configured to supply an electric bias EB to the bias electrode. The bias electrode may be at least one electrode provided in the conductive member of the base 1110 or the ceramic member 1111a. The bias electrode may be common to the radio frequency electrode. When the electric bias EB is supplied to the bias electrode, ions from the plasma are attracted to the substrate W.

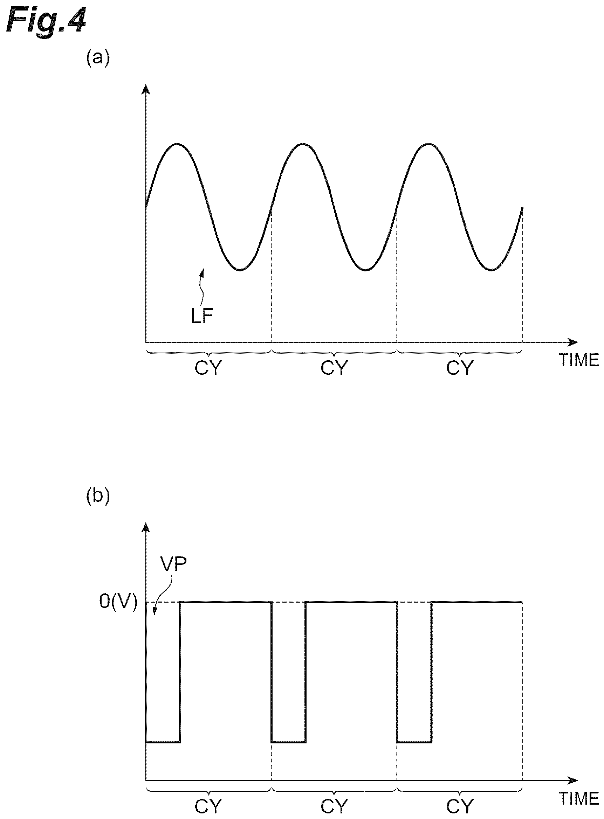

Hereinafter, reference is made to (a) of FIG. 4 and (b) of FIG. 4 together with FIGS. 2 and 3. Each of (a) of FIG. 4 and (b) of FIG. 4 is a diagram illustrating an example of a waveform of the electric bias. The bias power supply 32 is configured to periodically apply the electric bias EB having a waveform cycle CY to the bias electrode. That is, the electric bias EB is applied to the bias electrode in each of a plurality of waveform cycles CY which are repetitions of the waveform cycle CY. The waveform cycle CY is defined by a bias frequency. The bias frequency is, for example, a frequency of 50 kHz or higher and 27 MHz or lower. The time length of the waveform cycle CY is the reciprocal of the bias frequency.

As illustrated in (a) of FIG. 4, the electric bias EB may be bias radio frequency power LF having a bias frequency. That is, the electric bias EB may have a sinusoidal waveform of which a frequency is the bias frequency. In this case, the bias power supply 32 is electrically connected to the bias electrode via a matcher 34. The variable impedance of the matcher 34 is set to reduce the reflection from the load of the bias radio frequency power LF.

Alternatively, as illustrated in (b) of FIG. 4, the electric bias EB may include a voltage pulse VP. The voltage pulse VP is applied to the bias electrode in the waveform cycle CY. The voltage pulse VP is periodically applied to the bias electrode at a time interval equal to a length of the time length of the waveform cycle CY. The waveform of the voltage pulse VP may be a rectangular wave, a triangular wave, or any waveform. Polarity of the voltage of the voltage pulse VP is set so that a potential difference is generated between a substrate W and the plasma, and the ions from the plasma can be attracted onto the substrate W. The voltage pulse VP is applied to the bias electrode such that the waveform cycle CY includes a period in which the potential of the substrate W is a negative potential. The voltage pulse VP applied to the bias electrode may have a negative potential, may have a positive potential, or may have a potential that changes between a positive potential and a negative potential. The voltage pulse VP may be a negative voltage pulse or a negative direct current voltage pulse. In a case where the electric bias EB is the voltage pulse VP, the plasma processing apparatus 1 may not include the matcher 34.

In one embodiment, the bias power supply 32 may include a signal generator 32g, a D/A converter 32c, and an amplifier 32a as shown in FIG. 3. The signal generator 32g periodically generates a bias signal having a designated waveform and a waveform cycle CY. The signal generator 32g may be configured by a programmable logic device, such as a programmable processor or an FPGA.

An output of the signal generator 32g is connected to an input of the D/A converter 32c. The D/A converter 32c converts the bias signal from the signal generator 32g into an analog signal. An output of the D/A converter 32c is connected to an input of the amplifier 32a. The amplifier 32a amplifies the analog signal from the D/A converter 32c to generate the electric bias EB. The amplification factor of the amplifier 32a is designated from the controller 2 to the bias power supply 32. The bias power supply 32 may not include the D/A converter 32c. In this case, the output of the signal generator 32g is connected to the input of the amplifier 32a, and the amplifier 32a amplifies the bias signal from the signal generator 32g to generate the electric bias EB. In a case where the electric bias EB is the voltage pulse VP, the bias power supply 32 may periodically switch the output voltage between the output voltage of the high voltage power supply and the ground potential or another potential to periodically generate the voltage pulse VP.

The radio frequency power supply 31 is configured to determine the optimal temporal change pattern of the source frequency f_{S} in the waveform cycle CY which most suppresses the degree of reflection of the source radio frequency power HF, by changing the source frequency f_{S} in a time series of the plurality of waveform cycles CY. Hereinafter, the process of determining the optimal temporal change pattern of the source frequency f_{S} is referred to as "optimization process". In the optimization process, the radio frequency power supply 31 may set the source frequencies f_{S} at a plurality of discrete time points (phases) in each waveform cycle CY in the time series. Alternatively, the radio frequency power supply 31 may set the source frequency f_{S} continuously over time in each waveform cycle CY in the time series of the plurality of waveform cycles CY. The calculation of the optimization process can be performed in the signal generator 31g of the radio frequency power supply 31. The controller 2 may perform the calculation of the optimization process.

The plasma processing apparatus 1 may further include a sensor 35 and/or a sensor 36 to determine the degree of reflection of the source radio frequency power HF in the optimization process (see FIG. 2). The sensor 35 is configured to measure a power level Pr of a reflected wave of the source radio frequency power HF from a load. The sensor 35 includes, for example, a directional coupler. The directional coupler may be provided between the radio frequency power supply 31 and the matcher 33. The sensor 35 may be configured to further measure the power level Pf of the traveling wave of the source radio frequency power HF. The power level Pr of the reflected wave measured by the sensor 35 is notified to the radio frequency power supply 31. In addition, the power level Pf of the traveling wave may be notified from the sensor 35 to the radio frequency power supply 31.

The sensor 36 includes a voltage sensor and a current sensor. The sensor 36 is configured to measure a voltage V_{S} and a current I_{S} in a power feeding path that connects the radio frequency power supply 31 and the radio frequency electrode to each other. The source radio frequency power HF is supplied to the radio frequency electrode via the power feeding path. The sensor 36 may be provided between the radio frequency power supply 31 and the matcher 33. The voltage V_{S} and the current I_{S} are notified to the radio frequency power supply 31.

The radio frequency power supply 31 generates a representative value from the notified measurement value. The measurement value may be a power level Pr of the reflected wave acquired by the sensor 35. The measurement value may be a value of a ratio (that is, a reflectivity) of a power level Pr of a reflected wave to an output power level of the source radio frequency power HF. The measurement value may be a phase difference θ between the voltage V_{S} and the current I_{S} acquired by the sensor 36. The measurement value may be the impedance Z_{L} on the load side of the radio frequency power supply 31 in each of the plurality of phase periods SP. The impedance Z_{L} is determined from the voltage V_{S} and the current I_{S} acquired by the sensor 36. The measurement value may be a reflection coefficient obtained from the impedance Z_{L} and the output impedance of the radio frequency power supply 31. The representative value represents a degree of reflection of the source radio frequency power HF in each waveform cycle CY. The representative value may be an average value or a maximum value of the measurement values in each waveform cycle CY. Alternatively, the representative value may be an average value or a maximum value of the measurement values in a partial period in which the source frequency f_{S} is changed in each waveform cycle CY.

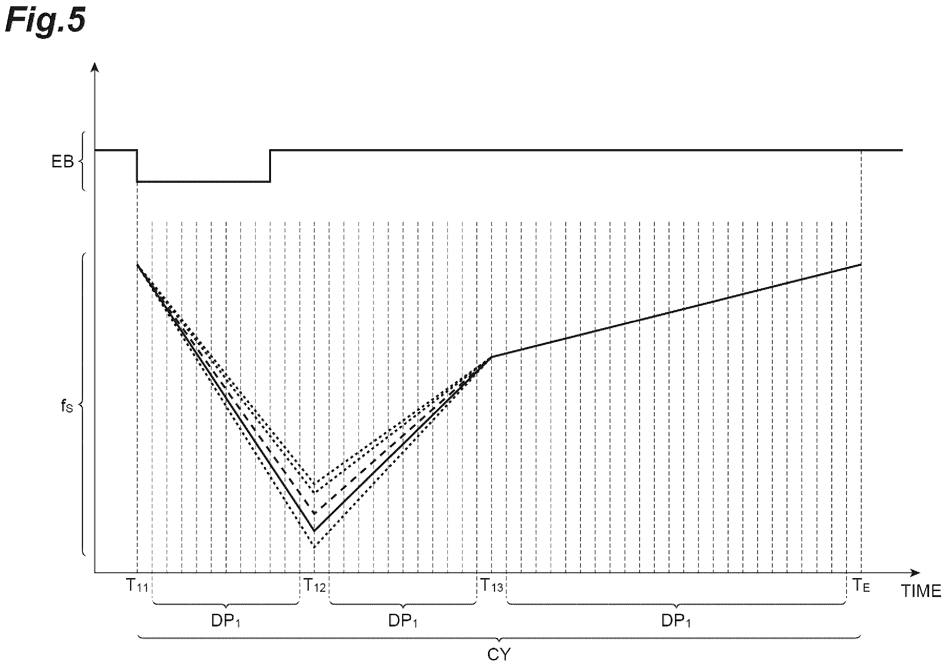

Hereinafter, the optimization process will be described in detail with reference to FIGS. 5 to 8. Each of FIGS. 5 to 8 is a diagram for describing an example of the optimization process of a temporal change pattern of a source frequency. The optimization process includes a first optimization process, ..., and a J-th optimization process sequentially. J may be any integer which is equal to or greater than 2. In the examples shown in FIGS. 5 to 7, J is 3.

In the optimization process, the radio frequency power supply 31 searches for an optimal time change pattern in the time series of the plurality of waveform cycles CY. In the optimization process, the radio frequency power supply 31 uses an initial temporal pattern of the source frequency f_{S} which is prepared in advance as the temporal pattern of the source frequency f_{S} of the initial waveform cycle CY in the time series.

Next, the radio frequency power supply 31 performs the first optimization process. In the first optimization process, the radio frequency power supply 31 determines the first temporal change pattern of the source frequency f_{S} in the waveform cycle CY which most suppresses the degree of reflection of the source radio frequency power HF.

In the first optimization process, the radio frequency power supply 31 uses a temporal change pattern of a source frequency f_{S} including a source frequency f_{S} of each of a plurality of first time points (phases) and an interpolated source frequency f_{S} in each of a plurality of first division periods DP₁, in each waveform cycle CY in the time series.

The number of the plurality of first time points in each waveform cycle CY is equal to or greater than 2. In the example shown in FIG. 5, the plurality of first time points include a time point T₁₁ to a time point T₁₃. The waveform cycle CY is divided into the plurality of first division periods DP₁ by the plurality of first time points. In the example shown in FIG. 5, the plurality of first division periods DP₁ include a period between the time point T₁₁ and the time point T₁₂, a period between the time point T₁₂ and the time point T₁₃, and a period between the time point T₁₃ and a final time point T_{E} in the waveform cycle CY. The source frequency f_{S} at the initial first time point T₁₁ and the source frequency f_{S} at the final time point T_{E} in the waveform cycle CY are the same.

The plurality of first time points (phases) in each waveform cycle CY may be predetermined. Alternatively, the plurality of first time points may be set such that each of the plurality of first division periods DP₁ has the first change amount as the change amount of the load impedance of the radio frequency power supply 31 with respect to the above-described initial temporal pattern. Alternatively, the plurality of first time points may be set such that each of the plurality of first division periods DP₁ has the first change amount as the change amount in the source frequency with respect to the above-described initial temporal pattern. Alternatively, the plurality of first time points may be set such that a section in the waveform cycle CY is divided into a greater number of division periods as the load impedance of the radio frequency power supply 31 or the degree of reflection of the source radio frequency power HF is greater in the section. Alternatively, in a case where the electric bias EB includes the voltage pulse VP, the plurality of first time points may be set such that a section in the waveform cycle CY is divided into a greater number of division periods as the change amount in the voltage in the substrate support 11 according to the voltage pulse VP is greater in the section. Alternatively, in a case where the electric bias EB includes the voltage pulse VP, one of the plurality of first division periods DP₁ may include a period in which the voltage pulse VP is supplied to the substrate support 11.

In the first optimization process, the radio frequency power supply 31 changes the temporal change pattern of the source frequency f_{S} of the waveform cycle CYₘ in the time series from a temporal change pattern of the source frequency f_{S} in a preceding waveform cycle CY_{m-M1}. Specifically, the radio frequency power supply 31 sequentially changes the respective source frequencies f_{S} at the plurality of first time points in the time series of the plurality of waveform cycles CY. More specifically, the radio frequency power supply 31 sets the source frequency f_{S}[m, T₁ₙ] at the first time point T₁ₙ in the waveform cycle CYₘ in the time series to a frequency having one change with respect to the source frequency f_{S}[m-M1, T₁ₙ] at the first time point T₁ₙ in the preceding waveform periphery CY_{m-M1}. The one change is a decrease or an increase in frequency. "m" is a natural number representing an order of the waveform cycle CY in the time series. "n" is a natural number representing an order of each of the plurality of first time points in the waveform cycle CY. "M1" is an integer which is equal to or greater than 1, and is, for example, 1. In addition, f_{S}[m, T₁ₙ] represents a source frequency f_{S} at a first time point T₁ₙ in the waveform cycle CYₘ.

The radio frequency power supply 31 interpolates the source frequency f_{S} of each of the plurality of first division periods DP₁ from the source frequency f_{S} at the immediately before time point and the source frequency f_{S} at the immediately after time point among the plurality of first time points and the time point T_{E}. The radio frequency power supply 31 can use linear interpolation in the interpolation of the source frequency f_{S}. Alternatively, the radio frequency power supply 31 may use interpolation by a high-order expression in the interpolation of the source frequency f_{S}. In the example shown in FIG. 5, a situation in which the source frequency f_{S} at the first time point T₁₂ is changed is shown.

In the first optimization process, in a case where the degree of reflection of the source radio frequency power HF is reduced due to the one change, the radio frequency power supply 31 sets the source frequency f_{S}[m+M1, T₁ₙ] in the subsequent waveform cycle CY_{m+M1} in the time series to a frequency having the one change with respect to the source frequency f_{S}[m, T₁ₙ]. In a case where the degree of reflection of the source radio frequency power HF is increased due to the one change, the radio frequency power supply 31 sets the frequency f_{S}[m+M1, T₁ₙ] in the subsequent waveform cycle CY_{m+M1} in the time series to a frequency having the other change with respect to the source frequency f_{S}[m, T₁ₙ]. The other change is a decrease or an increase in frequency, which is a change opposite to the one change.

The radio frequency power supply 31 may sequentially optimize the respective source frequencies f_{S} of the plurality of first time points to suppress the degree of reflection of the source radio frequency power HF to determine the first temporal change pattern in the first optimization process. Alternatively, the radio frequency power supply 31 may determines the first temporal change pattern by repeating the sequential adjustment (or change) of the respective source frequencies f_{S} of the plurality of first time points to determine the first temporal change pattern. In any case, the order of the first time points, at which the source frequency f_{S} is optimized or adjusted, among the plurality of first time points may be predetermined, or may be any order. For example, the source frequency f_{S} may be optimized or adjusted sequentially from a time point at which it is empirically known that the change in the source frequency f_{S} at that time point has a large influence on the degree of reflection among the plurality of first time points.

In the first optimization process, the radio frequency power supply 31 determines, as the first temporal change pattern, the temporal change pattern of the source frequency f_{S} of the waveform cycle CY in a case where the degree of reflection of the source radio frequency power HF satisfies a first condition. The first condition is predetermined as a condition indicating that the degree of reflection of the source radio frequency power HF is sufficiently suppressed. For example, the first condition may be satisfied in a case where the degree of reflection of the source radio frequency power HF is included in a first allowable range. In FIG. 5, the initial temporal pattern is shown by a solid line, and the temporal change pattern used in the first optimization process is shown by a broken line.

The radio frequency power supply 31 performs the second optimization process after the first optimization process. In the second optimization process, the radio frequency power supply 31 determines the second temporal change pattern of the source frequency f_{S} in the waveform cycle CY which most suppresses the degree of reflection of the source radio frequency power HF, based on the first reference pattern. The first reference pattern is the first temporal change pattern or a first derived temporal pattern of a source frequency f_{S} generated from the first temporal change pattern.

In the second optimization process, the radio frequency power supply 31 uses a temporal change pattern of a source frequency f_{S} including the respective source frequencies f_{S} of a plurality of second time points (phases) and an interpolated source frequency f_{S} in each of a plurality of second division periods DP₂, in each waveform cycle CY in the time series.

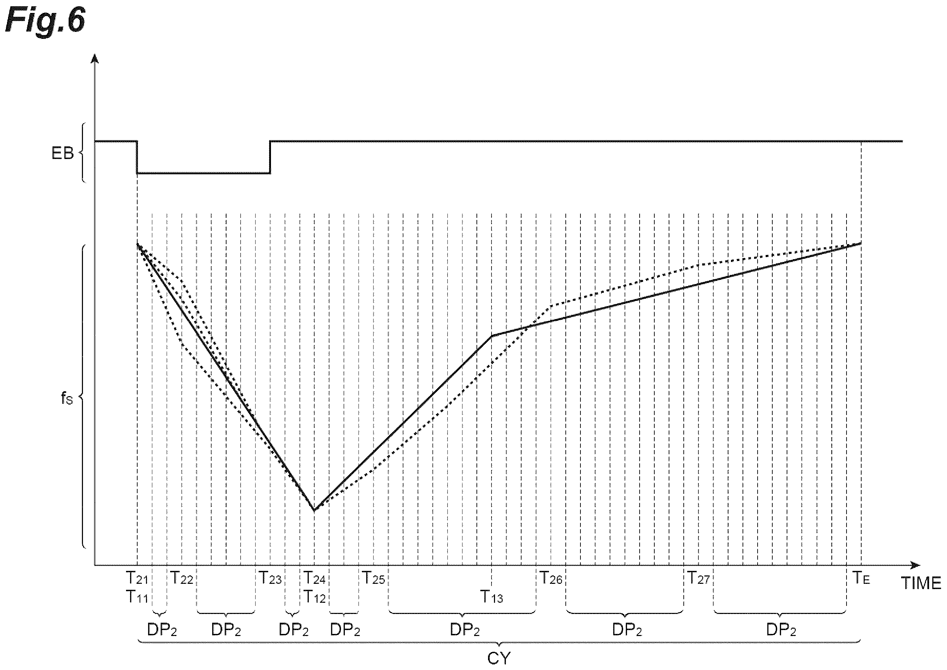

The number of the plurality of second time points in each waveform cycle CY is greater than the number of the plurality of first time points in each waveform cycle CY in the first optimization process. In the example shown in FIG. 6, the plurality of second time points include a time point T₂₁ to a time point T₂₇. The waveform cycle CY is divided into the plurality of second division periods DP₂ by the plurality of second time points. The number of the plurality of second division periods DP₂ in each waveform cycle CY is greater than the number of the plurality of first division periods DP₁ in the waveform cycle CY in the first optimization process. In the example shown in FIG. 6, the plurality of second division periods DP₂ include a period between the time point T₂₁ and the time point T₂₂, a period between the time point T₂₂ and the time point T₂₃, a period between the time point T₂₃ and the time point T₂₄, a period between the time point T₂₄ and the time point T₂₅, a period between the time point T₂₅ and the time point T₂₆, a period between the time point T₂₆ and the time point T₂₇, and a period between the time point T₂₇ and the final time point T_{E} in the waveform cycle CY. The source frequency f_{S} at the initial second time point T₂₁ and the source frequency f_{S} at the final time point T_{E} in the waveform cycle CY are the same.

A plurality of second time points (phases) in each waveform cycle CY may be predetermined. Alternatively, the plurality of second time points may be set such that each of the plurality of second division periods DP₂ has the second change amount as the change amount of the load impedance of the radio frequency power supply 31 with respect to the first reference pattern described above. In this case, the second change amount is smaller than the first change amount. Alternatively, the plurality of second time points may be set such that each of the plurality of second division periods DP₂ has the second change amount as the change amount in the source frequency with respect to the first reference pattern. Even in this case, the second change amount is smaller than the first change amount. Alternatively, the plurality of second time points may be set such that a section in the waveform cycle CY is divided into a greater number of division periods as the load impedance of the radio frequency power supply 31 or the degree of reflection of the source radio frequency power HF is greater in the section. Alternatively, in a case where the electric bias EB includes the voltage pulse VP, the plurality of second time points may be set such that a section in the waveform cycle CY is divided into a greater number of division periods as the change amount in the voltage in the substrate support 11 according to the voltage pulse VP is greater in the section. The plurality of second time points may include a plurality of time points that are the same as the plurality of first time points in the waveform cycle CY.

In the second optimization process, the radio frequency power supply 31 changes the temporal change pattern of the source frequency f_{S} of the waveform cycle CYₘ in the time series from a temporal change pattern of the source frequency f_{S} in a preceding waveform cycle CY_{m-M2}. In the initial stage of the second optimization process, the temporal change pattern of the source frequency f_{S} of the waveform cycle CY is obtained by changing the first reference pattern.

Specifically, the radio frequency power supply 31 sequentially changes the respective source frequencies f_{S} at the plurality of second time points in the time series of the plurality of waveform cycles CY. More specifically, in the second optimization process, the radio frequency power supply 31 sets the source frequency f_{S}[m, T₂ₙ] at the second time point T₂ₙ in the waveform cycle CYₘ in the time series to a frequency having one change with respect to the source frequency f_{S}[m-M2, T₂ₙ] at the second time point T₂ₙ in the preceding waveform periphery CY_{m-M2}. The one change is a decrease or an increase in frequency. "m" is a natural number representing an order of the waveform cycle CY in the time series. "n" is a natural number representing an order of each of the plurality of second time points in the waveform cycle CY. "M2" is an integer which is equal to or greater than 1, and is, for example, 1. In addition, f_{S}[m, T₂ₙ] represents the source frequency f_{S} at the second time point T₂ₙ in the waveform cycle CYₘ.

The radio frequency power supply 31 interpolates the respective source frequencies f_{S} of the plurality of second division periods DP₂ from the source frequency f_{S} at the immediately before time point and the source frequency f_{S} at the immediately after time point among the plurality of second time points and the time point T_{E}. The radio frequency power supply 31 can use linear interpolation in the interpolation of the source frequency f_{S}. Alternatively, the radio frequency power supply 31 may use interpolation by a high-order expression in the interpolation of the source frequency f_{S}.

In the second optimization process, in a case where the degree of reflection of the source radio frequency power HF is reduced due to the one change, the radio frequency power supply 31 sets the source frequency f_{S}[m+M2, T₂ₙ] in the subsequent waveform cycle CY_{m+M2} in the time series to a frequency having the one change with respect to the source frequency f_{S}[m, T₂ₙ]. In a case where the degree of reflection of the source radio frequency power HF is increased due to the one change, the radio frequency power supply 31 sets the frequency f_{S}[m+M2, T₂ₙ] in the subsequent waveform cycle CY_{m+M2} in the time series to a frequency having the other change with respect to the source frequency f_{S}[m, T₂ₙ]. The other change is a decrease or an increase in frequency, which is a change opposite to the one change.

The radio frequency power supply 31 may sequentially optimize the respective source frequencies f_{S} of the plurality of second time points to suppress the degree of reflection of the source radio frequency power HF to determine the second temporal change pattern in the second optimization process. Alternatively, the radio frequency power supply 31 may determine the second temporal change pattern by repeating the sequential adjustment (or change) of the respective source frequencies f_{S} at the plurality of second time points to determine the second temporal change pattern. In any case, the order of the plurality of second time points at which the source frequency f_{S} is optimized or adjusted may be predetermined among the plurality of second time points, or may be any order. For example, the source frequency f_{S} may be optimized or adjusted sequentially from a time point at which it is empirically known that the change in the source frequency f_{S} at that time point has a large influence on the degree of reflection among the plurality of second time points.

In the second optimization process, the radio frequency power supply 31 determines, as the second temporal change pattern, the temporal change pattern of the source frequency f_{S} of the waveform cycle CY in a case where the degree of reflection of the source radio frequency power HF satisfies a second condition. The second condition is predetermined as a condition indicating that the degree of reflection of the source radio frequency power HF is sufficiently suppressed. For example, the second condition may be satisfied in a case where the degree of reflection of the source radio frequency power HF is included in a second allowable range. In FIG. 6, the first reference pattern is shown by a solid line, and the temporal change pattern used in the second optimization process is shown by a broken line.

The radio frequency power supply 31 may further perform a third optimization process after the second optimization process. Further, the radio frequency power supply 31 may further perform a fourth optimization process after the third optimization process. Hereinafter, the j-th optimization process which represents each of the second optimization process to the J-th optimization process will be described using a reference numeral "j" as a reference numeral indicating an order of each optimization process.

In the j-th optimization process, the radio frequency power supply 31 determines the j-th temporal change pattern of the source frequency f_{S} in the waveform cycle CY which most suppresses the degree of reflection of the source radio frequency power HF, based on the (j-1)-th reference pattern. The (j-1)-th reference pattern is a (j-1)-th temporal change pattern or a (j-1)-th derived temporal pattern of a source frequency f_{S} generated from the (j-1)-th temporal change pattern.

In the j-th optimization process, the radio frequency power supply 31 uses a temporal change pattern of a source frequency f_{S} including the respective source frequencies f_{S} of a plurality of j-th time points (phases) in each waveform cycle CY and an interpolated source frequency f_{S} in each of a plurality of j-th division periods DPⱼ, in the time series.

The number of the plurality of j-th time points in each waveform cycle CY is greater than the number of the plurality of j-th time points in each waveform cycle CY in the (j-1)-th optimization process. The waveform cycle CY is divided into the plurality of j-th division periods DPⱼ by a plurality of j-th time points. The number of the plurality of j-th division periods DPⱼ in each waveform cycle CY is greater than the number of the plurality of (j-1)-th division periods DP₍ⱼ₋₁₎ in the waveform cycle CY in the (j-1)-th optimization process. The source frequency f_{S} at the initial j-th time point Tⱼ₁ and the source frequency f_{S} at the final time point T_{E} in the waveform cycle CY are the same.

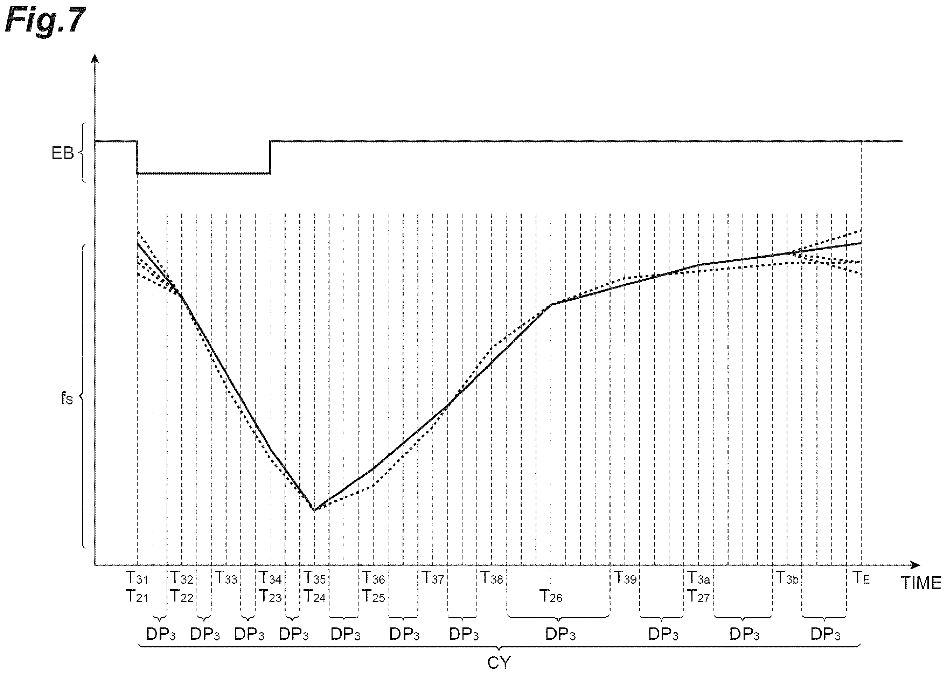

In the example shown in FIG. 7, the plurality of third time points include a time point T₃₁ to a time point T_{3b}. In the example shown in FIG. 7, the plurality of third division periods DP₃ include a period between the time point T₃₁ and the time point T₃₂, a period between the time point T₃₂ and the time point T₃₃, a period between the time point T₃₃ and the time point T₃₄, a period between the time point T₃₄ and the time point T₃₅, a period between the time point T₃₅ and the time point T₃₆, a period between the time point ₃₆ and the time point T₃₇, a period between the time point ₃₇ and the time point T₃₈, a period between the time point ₃₇ and the time point T₃₈, a period between the time point ₃₈ and the time point T₃₉, a period between the time point ₃₉ and the time point T₃ₐ, a period between the time point ₃ₐ and the time point T_{3b}, and a period between the time point T_{3b} and the final time point T_{E} in the waveform cycle CY. The source frequency f_{S} at the initial third time point T3₁ and the source frequency f_{S} at the final time point T_{E} in the waveform cycle CY are the same.

A plurality of j-th time points (phases) in each waveform cycle CY may be predetermined. Alternatively, the plurality of j-th time points may be set such that each of the plurality of j-th division periods DPⱼ has the j-th change amount as the change amount of the load impedance of the radio frequency power supply 31 with respect to the (j-1)-th reference pattern described above. In this case, the j-th change amount is smaller than the (j-1)-th change amount. Alternatively, the plurality of j-th time points may be set such that each of the plurality of j-th division periods DPⱼ has the j-th change amount as the change amount in the source frequency with respect to the (j-1)-th reference pattern. Even in this case, the j-th change amount is smaller than the (j-1)-th change amount. Alternatively, the plurality of j-th time points may be set such that a section in the waveform cycle CY is divided into a greater number of division periods as the load impedance of the radio frequency power supply 31 or the degree of reflection of the source radio frequency power HF is greater in the section. Alternatively, in a case where the electric bias EB includes the voltage pulse VP, the plurality of j-th time points may be set such that a section in the waveform cycle CY is divided into a greater number of division periods as the change amount in the voltage in the substrate support 11 according to the voltage pulse VP is greater in the section. The plurality of j-th time points may include a plurality of time points that are the same as the plurality of (j-1)-th time points in the waveform cycle CY, respectively.

In the j-th optimization process, the radio frequency power supply 31 changes the temporal change pattern of the source frequency f_{S} of the waveform cycle CYₘ in the time series from a temporal change pattern of the source frequency f_{S} in a preceding waveform cycle CY_{m-Mj}. In the initial stage of the second optimization process, the temporal change pattern of the source frequency f_{S} of the waveform cycle CY is obtained by changing the (j-1)-th reference pattern.

Specifically, the radio frequency power supply 31 sequentially changes the source frequency f_{S} at each of the plurality of j-th time points in the time series of the plurality of waveform cycles CY. More specifically, in the j-th optimization process, the radio frequency power supply 31 sets the source frequency f_{S}[m, Tⱼₙ] at the j-th time point Tⱼₙ in the waveform cycle CYₘ in the time series to a frequency having one change with respect to the source frequency f_{S}[m-Mj, Tⱼₙ] at the j-th time point Tⱼₙ in the preceding waveform periphery CY_{m-Mj}. The one change is a decrease or an increase in frequency. "m" is a natural number representing an order of the waveform cycle CY in the time series. "n" is a natural number representing an order of each of the plurality of j-th time points in the waveform cycle CY. "Mj" is an integer which is equal to or greater than 1, and is, for example, 1. In addition, f_{S}[m, Tⱼₙ] represents the source frequency f_{S} at the j-th time point Tⱼₙ in the waveform cycle CYₘ.

The radio frequency power supply 31 interpolates the source frequency f_{S} of each of the plurality of j-th division periods DPⱼ from the source frequency f_{S} at the immediately before time point and the source frequency f_{S} at the immediately after time point among the plurality of j-th time points and the time point T_{E}. The radio frequency power supply 31 can use linear interpolation in the interpolation of the source frequency f_{S}. Alternatively, the radio frequency power supply 31 may use interpolation by a high-order expression in the interpolation of the source frequency f_{S}.

In the j-th optimization process, in a case where the degree of reflection of the source radio frequency power HF is reduced due to the one change, the radio frequency power supply 31 sets the source frequency f_{S}[m+Mj, Tⱼₙ] in the subsequent waveform cycle CY_{m+Mj} in the time series to a frequency having the one change with respect to the source frequency f_{S}[m, Tⱼₙ]. In a case where the degree of reflection of the source radio frequency power HF is increased due to the one change, the radio frequency power supply 31 sets the frequency f_{S}[m+Mj, Tⱼₙ] in the subsequent waveform cycle CY_{m+Mj} in the time series to a frequency having the other change with respect to the source frequency f_{S}[m, Tⱼₙ]. The other change is a decrease or an increase in frequency, which is a change opposite to the one change.

The radio frequency power supply 31 may sequentially optimize the respective source frequencies f_{S} of the plurality of j-th time points to suppress the degree of reflection of the source radio frequency power HF to determine the j-th temporal change pattern in the j-th optimization process. Alternatively, the radio frequency power supply 31 may determine the j-th temporal change pattern by repeating the sequential adjustment (or change) of the source frequency f_{S} of each of the plurality of j-th time points to determine the j-th temporal change pattern. In any case, the order of the time point at which the source frequency f_{S} is optimized or adjusted among the plurality of j-th time points may be predetermined, or may be any order. For example, the source frequency f_{S} may be optimized or adjusted sequentially from a time point at which it is empirically known that the change in the source frequency f_{S} at that time point has a large influence on the degree of reflection among the plurality of j-th time points.

In the j-th optimization process, the radio frequency power supply 31 determines, as the j-th temporal change pattern, the temporal change pattern of the source frequency f_{S} of the waveform cycle CY in a case where the degree of reflection of the source radio frequency power HF satisfies the j-th condition. The j-th condition is predetermined as a condition indicating that the degree of reflection of the source radio frequency power HF is sufficiently suppressed. For example, the j-th condition may be satisfied in a case where the degree of reflection of the source radio frequency power HF is included in a j-th allowable range. In FIG. 7, the third reference pattern is shown by a solid line, and the temporal change pattern used in the third optimization process is shown by a broken line.

The radio frequency power supply 31 may use the temporal change pattern, which is obtained by the final optimization process and most suppresses the degree of reflection in the waveform cycle CY, as the optimal temporal change pattern, and may use the temporal change pattern in the subsequent waveform cycle CY in the time series.

In one embodiment, in a case where the degree of reflection of the source radio frequency power HF becomes large and does not satisfy the predetermined condition while the j-th optimization process (j is an integer which is equal to or greater than 2) is performed, the radio frequency power supply 31 may perform the first optimization process again. After that, the radio frequency power supply 31 may further perform the second to J-th optimization processes. According to the embodiment, in a case where abnormal discharge of plasma occurs during the j-th optimization process, it is possible to search for the temporal change pattern of the source frequency HF that suppresses the degree of reflection of the source radio frequency power HF within the waveform cycle CY again.

In one embodiment, the radio frequency power supply 31 may obtain the (j-1)-th derived temporal pattern of the source frequency f_{S} from the (j-1)-th temporal change pattern after the (j-1)-th optimization process and before the j-th optimization process.

Specifically, the radio frequency power supply 31 shifts the (j-1)-th temporal change pattern in the temporal direction in a plurality of waveform cycles CY in the time series. The minimum amount of shift in the temporal direction may be smaller than a time pitch of a plurality of discrete time points at which the source frequency is set in the waveform cycle CY. The radio frequency power supply 31 may determine, as the (j-1)-th derived temporal pattern, a temporal change pattern which most suppresses the degree of reflection of the source radio frequency power HF in the waveform cycle CY among the plurality of temporal change patterns obtained by shifting the (j-1)-th temporal change pattern in the temporal direction. The (j-1)-th derived temporal pattern can be used as a (j-1)-th reference pattern in the j-th optimization process.

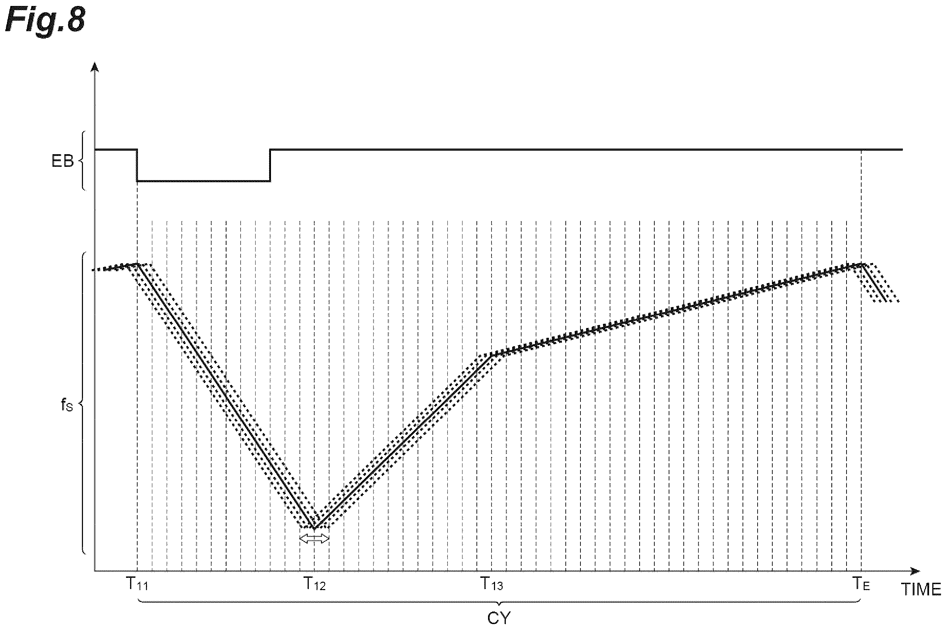

In the example shown in FIG. 8, the radio frequency power supply 31 obtains the derived temporal pattern of the source frequency f_{S} from the first temporal change pattern after the first optimization process and before the second optimization process. The radio frequency power supply 31 shifts the first temporal change pattern in the temporal direction in a plurality of waveform cycles CY in the time series. The radio frequency power supply 31 may determine, as the first derived temporal pattern, a temporal change pattern which most suppresses the degree of reflection of the source radio frequency power HF among the plurality of temporal change patterns obtained by shifting the first temporal change pattern in the temporal direction. The first derived temporal pattern can be used as a first reference pattern in the second optimization process. In FIG. 8, a solid line indicates the first temporal change pattern, and a broken line indicates the plurality of temporal change patterns obtained by shifting the first temporal change pattern in the temporal direction.

The above-described process of determining the temporal change pattern for suppressing reflection by shifting the temporal change pattern of the source frequency f_{S} in the waveform cycle CY in the temporal direction may be used at any timing in each of the first to J-th optimization processes.

In one embodiment, the source radio frequency power HF and the electric bias EB are supplied simultaneously and continuously. That is, in one embodiment, a continuous wave of the source radio frequency power HF and a continuous wave of the electric bias EB are simultaneously supplied. In a case where the continuous wave of the source radio frequency power HF and the continuous wave of the electric bias EB are simultaneously supplied, the first process, which is one type of the above-described optimization process, is applied. In the first process, the above-described optimization process is applied to a plurality of consecutive waveform cycles CY as the plurality of waveform cycles CY in the time series.

In another embodiment, the bias power supply 32 periodically supplies the pulse EBP of the electric bias EB to the bias electrode. The pulse EBP is supplied to the bias electrode in each of a plurality of pulse periods PP. Each of the plurality of pulse periods PP includes repetition of the waveform cycle CY. That is, in each of the plurality of pulse periods PP, the electric bias EB is periodically supplied to the bias electrode.

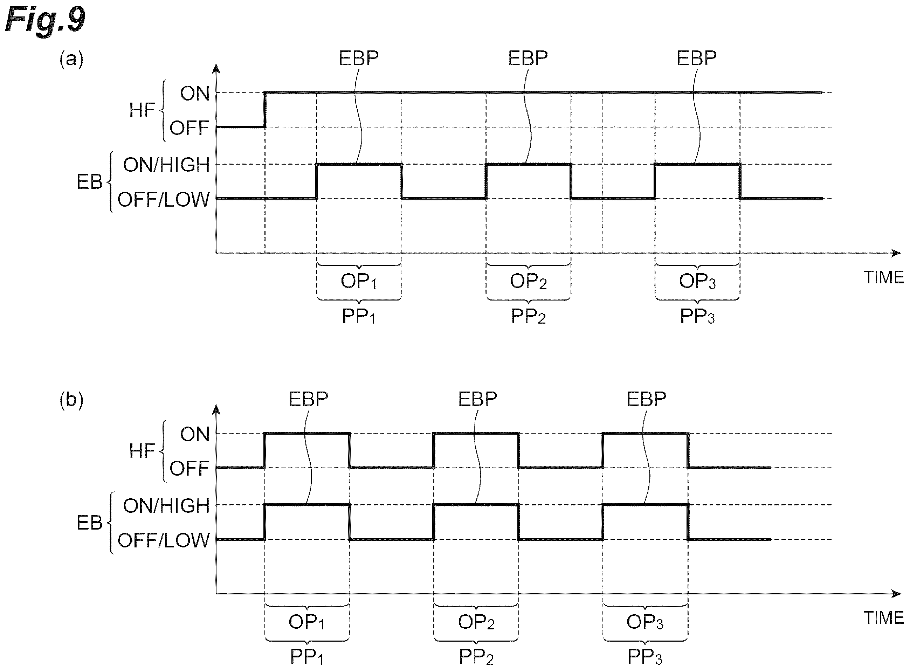

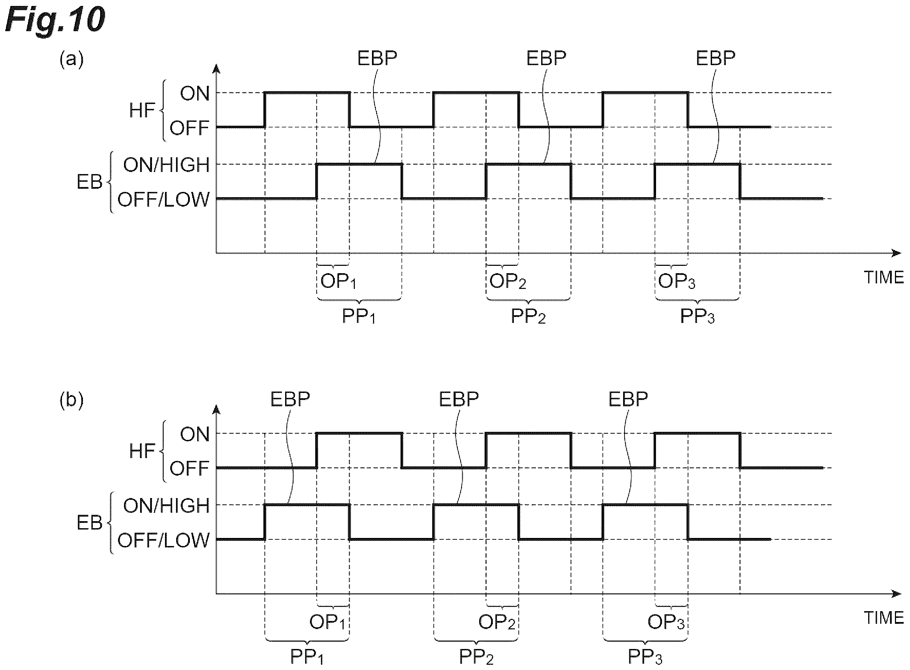

Here, (a) of FIG. 9, (b) of FIG. 9, (a) of FIG. 10, and (b) of FIG. 10 are referred to. Each of (a) of FIG. 9, (b) of FIG. 9, (a) of FIG. 10, and (b) of FIG. 10 is a timing chart of an example of the source radio frequency power HF and the electric bias EB. In each drawing, "ON" of the source radio frequency power HF indicates that the source radio frequency power HF is supplied, and "OFF" of the source radio frequency power HF indicates that the supply of the source radio frequency power HF is stopped. In addition, in the drawings, "ON" of the electric bias EB indicates that the electric bias EB is applied to the bias electrode, and "OFF" of the electric bias EB indicates that the electric bias EB is not applied to the bias electrode. In addition, in the drawings, "HIGH" of the electric bias EB indicates that the electric bias EB having a level higher than the level of the electric bias EB indicated by "LOW" is applied to the bias electrode.

The plurality of pulse periods PP appear in temporal sequence. The plurality of pulse periods PP sequentially appear at time intervals (periods) that are the reciprocal of the pulse frequency. In the following description, a pulse period PPₖ represents a k-th pulse period among the plurality of pulse periods PP. The pulse frequency is lower than the bias frequency, and is, for example, a frequency which is equal to or higher than 1 kHz and equal to or lower than 100 kHz. As described above, the electric bias EB is periodically applied to the bias electrode in each of the plurality of pulse periods PP. In a period other than the plurality of pulse periods PP, the electric bias EB may not be applied to the bias electrode. Alternatively, the electric bias EB having a level lower than the level of the electric bias EB in the plurality of pulse periods PP may be applied to the bias electrode in a period other than the plurality of pulse periods PP.

As shown in (a) of FIG. 9, the source radio frequency power HF may be supplied as a continuous wave. In the example shown in (a) of FIG. 9, a plurality of overlapping periods OP in which the source radio frequency power HF and the electric bias EB are simultaneously supplied match the plurality of pulse periods PP, respectively.

Alternatively, as shown in (b) of FIG. 9, (a) of FIG. 10, and (b) of FIG. 10, a pulse of the source radio frequency power HF may be supplied. As shown in (b) of FIG. 9, the pulse of the source radio frequency power HF may be supplied in each of the plurality of periods that respectively match a plurality of pulse periods PP. In the example shown in (b) of FIG. 9, the plurality of overlapping periods OP in which the source radio frequency power HF and the electric bias EB are simultaneously supplied match the plurality of pulse periods PP, respectively. As shown in (a) of FIG. 10 and (b) of FIG. 10, the pulse of the source radio frequency power HF may be supplied in each of the plurality of periods partially overlapping with the plurality of pulse periods PP. In the example shown in each of (a) and (b) of FIG. 10, each of the plurality of overlapping periods OP in which the source radio frequency power HF and the electric bias EB are simultaneously supplied is a part of the corresponding pulse period PP among the plurality of pulse periods PP. In the following description, an overlapping period OPₖ represents a k-th overlapping period among the plurality of overlapping periods OP. In addition, a waveform cycle CYₘ represents an m-th waveform cycle among the plurality of waveform cycles CY in each of the plurality of overlapping periods OP.

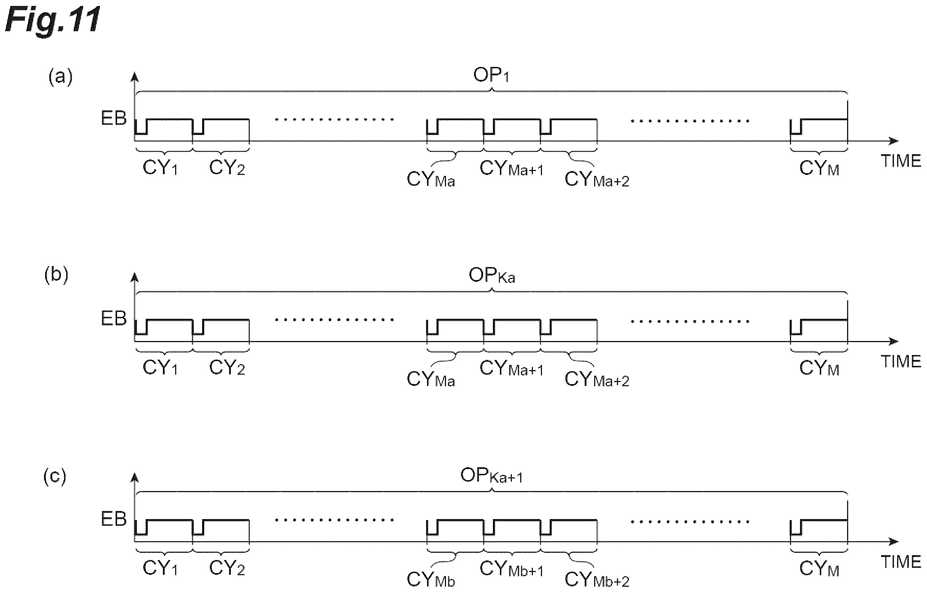

Hereinafter, the optimization process in a case where the bias power supply 32 periodically supplies the pulse EBP of the electric bias EB to the bias electrode will be described with reference to (a) of FIG. 11 to (c) of FIG. 11. Each of (a) of FIG. 11 to (c) of FIG. 11 is a timing chart of an example of the electric bias.

The radio frequency power supply 31 uses an initial temporal pattern prepared in advance as a temporal pattern of the source frequency f_{S} of each of the waveform cycles CY₁ to CY_{Ma} in each of the overlapping periods OP₁ to OP_{Ka}. Ka is an integer which is equal to or greater than 1, and is, for example, 5. In addition, Ma is an integer which is equal to or greater than 1.

The radio frequency power supply 31 performs the first process on the waveform cycle CY_{Ma+1} to the waveform cycle CYₘ in each of the overlapping periods OP₁ to OP_{Ka} as the time series of the plurality of consecutive waveform cycles CY.

In the overlapping period OP_{Ka+1} to the final overlapping period, the radio frequency power supply 31 applies the second process to each of a plurality of time series. Each of the plurality of time series includes a waveform cycle CYₘ of the same order among the waveform cycle CY₁ to the waveform cycle CY_{Mb} in each of the overlapping periods OP_{Ka+1} to the final overlapping period. That is, the plurality of time series include the first to Mb-th time series. Mb is an integer which is equal to or greater than 1. Each of the plurality of time series includes a plurality of waveform cycles CY. Specifically, the first time series includes the waveform cycle CY₁ in each of the overlapping periods OP_{Ka+1} to the final overlapping period. The second time series includes the waveform cycle CY₂ in each of the overlapping periods OP_{Ka+1} to the final overlapping period. The Mb-th time series includes the waveform cycle CY_{Mb} in each of the overlapping periods OP_{Ka+1} to the final overlapping period. In the second process, each of the plurality of time series is the time series of the plurality of waveform cycles CY to which the above-described optimization process (that is, the first optimization process to the J-th optimization process) is applied.

In addition, the radio frequency power supply 31 applies the first process described above to the waveform cycle CY_{Mb+1} to the waveform cycle CY_{M} in each of the overlapping period OP_{Ka+1} to the final overlapping period as the time series of the plurality of consecutive waveform cycles CY.

According to the plasma processing apparatus 1 described above, it is possible to reduce the degree of reflection of the source radio frequency power HF in the waveform cycle CY. In addition, according to the plasma processing apparatus 1, it is possible to smoothly change the source frequency f_{S} in each waveform cycle CY to suppress the degree of reflection of the source radio frequency power HF.

Hereinafter, a frequency control method according to one example embodiment will be described with reference to FIGS. 12 to 14.

FIG. 12 is a flowchart of a frequency control method according to one example embodiment. Each of FIGS. 13 and 14 is a flowchart illustrating an example of a step STA of the frequency control method according to one example embodiment. A frequency control method shown in FIG. 12 (hereinafter, referred to as a "method MT") may be performed using the plasma processing apparatus 1. In the method MT, each unit of the plasma processing apparatus 1 may be controlled by the controller 2.

The method MT starts in step STA. In step STA, the source radio frequency power HF is supplied from the radio frequency power supply 31 to generate the plasma from the gas in the chamber 10. In step STB, the electric bias EB is supplied to the bias electrode of the substrate support 11. Step STA is performed when step STB is being performed.

As shown in FIGS. 13 and 14, in step STa of step STA, the above-described initial temporal pattern is used as the temporal pattern of the source frequency f_{S} in one or more initial waveform cycles CY in the time series of the plurality of waveform cycles CY.

Next, in step STb to step STc of step STA, the first optimization process is performed. In the first optimization process, as described above, the respective source frequencies f_{S} at the plurality of first time points and the interpolated source frequency in each of the plurality of first division periods DP₁ are used, while the respective source frequency f_{S} at the plurality of first time points are changed in the time series of the plurality of waveform cycles CY.

In step STb, as described above for the first optimization process, the temporal change pattern of the source frequency f_{S} of the waveform cycle CYₘ in the time series is changed from the temporal change pattern of the source frequency f_{S} in the preceding waveform cycle CY_{m-M1}.

In subsequent step STJa, it is determined whether or not the degree of reflection of the source radio frequency power HF satisfies the first condition. In a case where the first condition is not satisfied, step STb is performed again. In a case where the first condition is satisfied, the temporal change pattern finally obtained in the first optimization process is determined as the first temporal change pattern in step STc.

The method MT may include a step STd performed after the first optimization process and before the second optimization process. In step STd, as described above, the temporal change pattern which most suppresses the degree of reflection of the source radio frequency power HF is determined as the first derived temporal pattern from among the plurality of temporal change patterns obtained by shifting the first temporal change pattern in the temporal direction.

In step STe to step STf of the method MT, the above-described second optimization process is performed. In the second optimization process, as described above, the respective source frequencies f_{S} at the plurality of second time points and the interpolated source frequency in each of the plurality of second division periods DP₂ are used, while the respective source frequency f_{S} at the plurality of second time points are changed in the time series of the plurality of waveform cycles CY.

In step STe, as described above for the second optimization process, the temporal change pattern of the source frequency f_{S} of the waveform cycle CYₘ in the time series is changed from the temporal change pattern of the source frequency f_{S} in the preceding waveform cycle CY_{m-M2}. In the initial stage of the second optimization process, the temporal change pattern of the source frequency f_{S} of the waveform cycle CY is obtained by changing the first reference pattern.

After step STe, step STJb may be performed. In step STJb, it is determined whether or not the degree of reflection of the source radio frequency power HF becomes large as the predetermined condition is not satisfied by using the changed temporal change pattern of the source frequency f_{S} in the waveform cycle CYₘ. As a result of the determination in STJb, in a case where it is determined that the degree of reflection of the source radio frequency power HF becomes large as the predetermined condition is not satisfied by using the changed temporal change pattern of the source frequency f_{S} in the waveform cycle CYₘ, the process returns to step STa. On the other hand, as a result of the determination in STJb, in a case where the degree of reflection of the source radio frequency power HF does not become large as the predetermined condition is not satisfied by using the changed temporal change pattern of the source frequency f_{S} in the waveform cycle CYₘ, the process proceeds to step STJc.

In the subsequent step STJc, it is determined whether or not the degree of reflection of the source radio frequency power HF satisfies the second condition described above. In a case where the second condition is not satisfied, step STe is performed again. In a case where the second condition is satisfied, the temporal change pattern finally obtained in the second optimization process is determined as the above-described second temporal change pattern in step STf.

The method MT may further include step STg to step STh. In step STg to step STh, the third optimization process is performed. In the third optimization process, as described above, the respective source frequencies f_{S} at the plurality of third time points and the interpolated source frequency in each of the plurality of third division periods DP₃ are used, while the respective source frequency f_{S} at each of a plurality of third time points are changed in the time series.

In step STg, as described above for the third optimization process, the temporal change pattern of the source frequency f_{S} of the waveform cycle CYₘ in the time series is changed from the temporal change pattern of the source frequency f_{S} in the preceding waveform cycle CY_{m-M3}. In the initial stage of the third optimization process, the temporal change pattern of the source frequency f_{S} of the waveform cycle CY is obtained by changing the second reference pattern.

After step STg, step STJd may be performed. In step STJd, it is determined whether or not the degree of reflection of the source radio frequency power HF becomes large as the predetermined condition is not satisfied by using the changed temporal change pattern of the source frequency f_{S} in the waveform cycle CYₘ. As a result of the determination of STJd, in a case where it is determined that the degree of reflection of the source radio frequency power HF becomes large as the predetermined condition is not satisfied by using the changed temporal change pattern of the source frequency f_{S} in the waveform cycle CYₘ, the process returns to step STa. On the other hand, as a result of the determination in STJd, in a case where the degree of reflection of the source radio frequency power HF does not become large as the predetermined condition is not satisfied by using the changed temporal change pattern of the source frequency f_{S} in the waveform cycle CYₘ, the process proceeds to step STJe.

In subsequent step STJe, it is determined whether or not the degree of reflection of the source radio frequency power HF satisfies a third condition. In a case where the third condition is not satisfied, step STg is performed again. In a case where the third condition is satisfied, the temporal change pattern finally obtained in the third optimization process is determined as the third temporal change pattern in step STh.

The method MT may be completed after step STh. Alternatively, in the method MT, the fourth to J-th optimization processes may be further performed as described above. For the fourth to J-th optimization processes, reference is made to the description of the j-th optimization process described above.

While various example embodiments have been described above, various additions, omissions, substitutions and changes may be made without being limited to the example embodiments described above. Elements of the different embodiments may be combined to form another embodiment.

In another embodiment, the plasma processing apparatus may be an inductively coupled plasma processing apparatus, an ECR plasma processing apparatus, a helical wave excitation plasma processing apparatus, or a surface wave plasma processing apparatus. In any plasma processing apparatus, source radio frequency power HF is used for generating plasma.

Here, various example embodiments included in the present disclosure are described in the following [E1] to [E16]

### [E1]

A plasma processing apparatus comprising:
a chamber;
a substrate support disposed in the chamber;
a radio frequency power supply configured to supply a source radio frequency power to generate plasma from a gas in the chamber; and
a bias power supply configured to supply an electric bias having a waveform cycle to the substrate support,
wherein the radio frequency power supply is configured to
   determine a first temporal change pattern of a source frequency of the source radio frequency power in the waveform cycle which most suppresses a degree of reflection of the source radio frequency power, by using respective source frequencies of the source radio frequency power at a plurality of first time points in the waveform cycle and an interpolated source frequency in each of a plurality of first division periods of the waveform cycle divided by the plurality of first time points, while changing the respective source frequency at the plurality of first time points, and
   determine a second temporal change pattern of the source frequency in the waveform cycle which most suppresses a degree of reflection of the source radio frequency power, by using the respective source frequencies of the source radio frequency power at a plurality of second time points in the waveform cycle and an interpolated source frequency in each of a plurality of second division periods of the waveform cycle divided by the plurality of second time points, while changing the respective source frequency at the plurality of second time points based on the first temporal change pattern or a temporal change pattern of the source frequency generated from the first temporal change pattern, and
a number of the plurality of second division periods is greater than a number of the plurality of first division periods.

### [E2]

The plasma processing apparatus according to E1,
wherein the radio frequency power supply is configured to
sequentially optimize the respective source frequencies at the plurality of first time points to suppress the degree of reflection of the source radio frequency power to determine the first temporal change pattern, and
sequentially optimize the respective source frequencies at the plurality of second time points to suppress the degree of reflection of the source radio frequency power to determine the second temporal change pattern.

### [E3]

The plasma processing apparatus according to E1,
wherein the radio frequency power supply is configured to
repeat sequentially adjusting the respective source frequencies of the plurality of first time points to determine the first temporal change pattern, and
repeat sequentially adjusting the respective source frequencies of the plurality of second time points to determine the second temporal change pattern.

### [E4]

The plasma processing apparatus according to any one of E1 to E3,
wherein the plurality of first time points and the plurality of second time points are predetermined.

### [E5]

The plasma processing apparatus according to any one of E1 to E3,
wherein the plurality of first time points are set such that each of the plurality of first division periods has a first change amount as a change amount of a load impedance of the radio frequency power supply with respect to a temporal change pattern of the source frequency in the waveform cycle that is initially used to determine the first temporal change pattern, and
the plurality of second time points are set such that each of the plurality of second division periods has a second change amount as a change amount of a load impedance of the radio frequency power supply with respect to the first temporal change pattern or the temporal change pattern of the source frequency generated from the first temporal change pattern.

### [E6]

The plasma processing apparatus according to E5,
wherein the second change amount is smaller than the first change amount.

### [E7]

The plasma processing apparatus according to any one of E1 to E3,
wherein the plurality of first time points are set such that each of the plurality of first division periods has a first change amount as a change amount of the source frequency with respect to a temporal change pattern of the source frequency in the waveform cycle that is initially used to determine the first temporal change pattern, and
the plurality of second time points are set such that each of the plurality of second division periods has a second change amount as a change amount of the source frequency with respect to the first temporal change pattern or the temporal change pattern created from the first temporal change pattern.

### [E8]

The plasma processing apparatus according to E7,
wherein the second change amount is smaller than the first change amount.

### [E9]

The plasma processing apparatus according to any one of E1 to E3,
wherein the plurality of first time points and the plurality of second time points are set such that a section in the waveform cycle is divided into a greater number of division periods as a load impedance of the radio frequency power supply or the degree of reflection of the source radio frequency power in the section is greater.

### [E10]

The plasma processing apparatus according to any one of E1 to E9,
wherein the electric bias is a bias radio frequency power having the waveform cycle, or the electric bias includes a voltage pulse generated at a time interval equal to a time length of the waveform cycle.

### [E11]

The plasma processing apparatus according to any one of E1 to E3,
wherein the electric bias includes a voltage pulse generated at a time interval equal to a time length of the waveform cycle, and
the plurality of first time points and the plurality of second time points are set such that a section within the waveform cycle is divided into a greater number of division periods as a change amount in a voltage in the substrate support according to the voltage pulse in the section is greater.

### [E12]

The plasma processing apparatus according to any one of E1 to E4,
wherein the electric bias includes a voltage pulse generated at a time interval equal to a time length of the waveform cycle, and
one of the plurality of first division periods includes a period during which the voltage pulse is supplied to the substrate support.

### [E13]

The plasma processing apparatus according to any one of E1 to E12,
wherein the radio frequency power supply is configured to
determine a temporal change pattern of the source frequency in the waveform cycle which most suppresses the degree of reflection of the source radio frequency power, by using a temporal change pattern obtained by shifting the first temporal change pattern in a temporal direction while changing an amount of shift in the temporal direction, and
use the determined temporal change pattern as the temporal change pattern of the source frequency generated from the first temporal change pattern.

### [E14]

The plasma processing apparatus according to any one of E1 to E13,
wherein the radio frequency power supply is configured to perform re-obtaining of the first temporal change pattern in a case where the degree of reflection of the source radio frequency power becomes so large that a predetermined reference is not satisfied when the second temporal change pattern is determined.

### [E15]

A power supply system comprising:
a radio frequency power supply configured to generate a source radio frequency power used to generate plasma; and
a bias power supply configured to generate an electric bias used to attract ions from the plasma, the electric bias having a waveform cycle,
wherein the radio frequency power supply is configured to
   determine a first temporal change pattern of a source frequency of the source radio frequency power in the waveform cycle which most suppresses a degree of reflection of the source radio frequency power, by using respective source frequencies of the source radio frequency power at a plurality of first time points in the waveform cycle and an interpolated source frequency in each of a plurality of first division periods of the waveform cycle divided by the plurality of first time points, while changing the respective source frequency at the plurality of first time points, and
   determine a second temporal change pattern of the source frequency in the waveform cycle which most suppresses a degree of reflection of the source radio frequency power, by using the respective source frequencies of the source radio frequency power at a plurality of second time points in the waveform cycle and an interpolated source frequency in each of a plurality of second division periods of the waveform cycle divided by the plurality of second time points, while changing the respective source frequency at the plurality of second time points based on the first temporal change pattern or a temporal change pattern of the source frequency generated from the first temporal change pattern, and
a number of the plurality of second division periods is greater than a number of the plurality of first division periods.

### [E16]

A frequency control method comprising:
supplying a source radio frequency power from a radio frequency power supply to generate plasma from gas in a chamber of a plasma processing apparatus; and
supplying an electric bias having a waveform cycle to a substrate support disposed in the chamber,
wherein the supplying a source radio frequency power includes
   determining a first temporal change pattern of a source frequency of the source radio frequency power in the waveform cycle which most suppresses a degree of reflection of the source radio frequency power, by using respective source frequencies of the source radio frequency power at a plurality of first time points in the waveform cycle and an interpolated source frequency in each of a plurality of first division periods of the waveform cycle divided by the plurality of first time points, while changing the respective source frequency at the plurality of first time points, and
   determining a second temporal change pattern of the source frequency in the waveform cycle which most suppresses a degree of reflection of the source radio frequency power, by using the respective source frequencies of the source radio frequency power at a plurality of second time points in the waveform cycle and an interpolated source frequency in each of a plurality of second division periods of the waveform cycle divided by the plurality of second time points, while changing the respective source frequency at the plurality of second time points based on the first temporal change pattern or a temporal change pattern of the source frequency generated from the first temporal change pattern, and
a number of the plurality of second division periods is greater than a number of the plurality of first division periods.

From the foregoing description, it will be appreciated that various embodiments of the present disclosure have been described herein for purposes of illustration, and that various modifications may be made without departing from the scope and spirit of the present disclosure. Accordingly, the various embodiments disclosed herein are not intended to be limiting, with the true scope and spirit being indicated by the following claims.

### Reference Signs List

- 1: plasma processing apparatus
- 10: chamber
- 11: substrate support
- 31: radio frequency power supply
- 32: bias power supply

## Claims

1. A plasma processing apparatus comprising:
a chamber;
a substrate support disposed in the chamber;
a radio frequency power supply configured to supply a source radio frequency power to generate plasma from a gas in the chamber; and
a bias power supply configured to supply an electric bias having a waveform cycle to the substrate support,
wherein the radio frequency power supply is configured to
determine a first temporal change pattern of a source frequency of the source radio frequency power in the waveform cycle which most suppresses a degree of reflection of the source radio frequency power, by using respective source frequencies of the source radio frequency power at a plurality of first time points in the waveform cycle and an interpolated source frequency in each of a plurality of first division periods of the waveform cycle divided by the plurality of first time points, while changing the respective source frequency at the plurality of first time points, and
determine a second temporal change pattern of the source frequency in the waveform cycle which most suppresses a degree of reflection of the source radio frequency power, by using the respective source frequencies of the source radio frequency power at a plurality of second time points in the waveform cycle and an interpolated source frequency in each of a plurality of second division periods of the waveform cycle divided by the plurality of second time points, while changing the respective source frequency at the plurality of second time points based on the first temporal change pattern or a temporal change pattern of the source frequency generated from the first temporal change pattern, and
a number of the plurality of second division periods is greater than a number of the plurality of first division periods.

2. The plasma processing apparatus according to Claim 1,
wherein the radio frequency power supply is configured to
sequentially optimize the respective source frequencies at the plurality of first time points to suppress the degree of reflection of the source radio frequency power to determine the first temporal change pattern, and
sequentially optimize the respective source frequencies at the plurality of second time points to suppress the degree of reflection of the source radio frequency power to determine the second temporal change pattern.

3. The plasma processing apparatus according to Claim 1,
wherein the radio frequency power supply is configured to
repeat sequentially adjusting the respective source frequencies of the plurality of first time points to determine the first temporal change pattern, and
repeat sequentially adjusting the respective source frequencies of the plurality of second time points to determine the second temporal change pattern.

4. The plasma processing apparatus according to any one of Claims 1 to 3,
wherein the plurality of first time points and the plurality of second time points are predetermined.

5. The plasma processing apparatus according to any one of Claims 1 to 3,
wherein the plurality of first time points are set such that each of the plurality of first division periods has a first change amount as a change amount of a load impedance of the radio frequency power supply with respect to a temporal change pattern of the source frequency in the waveform cycle that is initially used to determine the first temporal change pattern, and
the plurality of second time points are set such that each of the plurality of second division periods has a second change amount as a change amount of a load impedance of the radio frequency power supply with respect to the first temporal change pattern or the temporal change pattern of the source frequency generated from the first temporal change pattern.

6. The plasma processing apparatus according to Claim 5,
wherein the second change amount is smaller than the first change amount.

7. The plasma processing apparatus according to any one of Claims 1 to 3,
wherein the plurality of first time points are set such that each of the plurality of first division periods has a first change amount as a change amount of the source frequency with respect to a temporal change pattern of the source frequency in the waveform cycle that is initially used to determine the first temporal change pattern, and
the plurality of second time points are set such that each of the plurality of second division periods has a second change amount as a change amount of the source frequency with respect to the first temporal change pattern or the temporal change pattern created from the first temporal change pattern.

8. The plasma processing apparatus according to Claim 7,
wherein the second change amount is smaller than the first change amount.

9. The plasma processing apparatus according to any one of Claims 1 to 3,
wherein the plurality of first time points and the plurality of second time points are set such that a section in the waveform cycle is divided into a greater number of division periods as a load impedance of the radio frequency power supply or the degree of reflection of the source radio frequency power in the section is greater.

10. The plasma processing apparatus according to any one of Claims 1 to 3,
wherein the electric bias is a bias radio frequency power having the waveform cycle, or the electric bias includes a voltage pulse generated at a time interval equal to a time length of the waveform cycle.

11. The plasma processing apparatus according to any one of Claims 1 to 3,
wherein the electric bias includes a voltage pulse generated at a time interval equal to a time length of the waveform cycle, and
the plurality of first time points and the plurality of second time points are set such that a section within the waveform cycle is divided into a greater number of division periods as a change amount in a voltage in the substrate support according to the voltage pulse in the section is greater.

12. The plasma processing apparatus according to any one of Claims 1 to 3,
wherein the electric bias includes a voltage pulse generated at a time interval equal to a time length of the waveform cycle, and
one of the plurality of first division periods includes a period during which the voltage pulse is supplied to the substrate support.

13. The plasma processing apparatus according to any one of Claims 1 to 3,
wherein the radio frequency power supply is configured to
determine a temporal change pattern of the source frequency in the waveform cycle which most suppresses the degree of reflection of the source radio frequency power, by using a temporal change pattern obtained by shifting the first temporal change pattern in a temporal direction while changing an amount of shift in the temporal direction, and
use the determined temporal change pattern as the temporal change pattern of the source frequency generated from the first temporal change pattern.

14. The plasma processing apparatus according to any one of Claims 1 to 3,
wherein the radio frequency power supply is configured to perform re-obtaining of the first temporal change pattern in a case where the degree of reflection of the source radio frequency power becomes so large that a predetermined reference is not satisfied when the second temporal change pattern is determined.

15. A power supply system comprising:
a radio frequency power supply configured to generate a source radio frequency power used to generate plasma; and
a bias power supply configured to generate an electric bias used to attract ions from the plasma, the electric bias having a waveform cycle,
wherein the radio frequency power supply is configured to
determine a first temporal change pattern of a source frequency of the source radio frequency power in the waveform cycle which most suppresses a degree of reflection of the source radio frequency power, by using respective source frequencies of the source radio frequency power at a plurality of first time points in the waveform cycle and an interpolated source frequency in each of a plurality of first division periods of the waveform cycle divided by the plurality of first time points, while changing the respective source frequency at the plurality of first time points, and
determine a second temporal change pattern of the source frequency in the waveform cycle which most suppresses a degree of reflection of the source radio frequency power, by using the respective source frequencies of the source radio frequency power at a plurality of second time points in the waveform cycle and an interpolated source frequency in each of a plurality of second division periods of the waveform cycle divided by the plurality of second time points, while changing the respective source frequency at the plurality of second time points based on the first temporal change pattern or a temporal change pattern of the source frequency generated from the first temporal change pattern, and
a number of the plurality of second division periods is greater than a number of the plurality of first division periods.

16. A frequency control method comprising:
supplying a source radio frequency power from a radio frequency power supply to generate plasma from gas in a chamber of a plasma processing apparatus; and
supplying an electric bias having a waveform cycle to a substrate support disposed in the chamber,
wherein the supplying a source radio frequency power includes
determining a first temporal change pattern of a source frequency of the source radio frequency power in the waveform cycle which most suppresses a degree of reflection of the source radio frequency power, by using respective source frequencies of the source radio frequency power at a plurality of first time points in the waveform cycle and an interpolated source frequency in each of a plurality of first division periods of the waveform cycle divided by the plurality of first time points, while changing the respective source frequency at the plurality of first time points, and
determining a second temporal change pattern of the source frequency in the waveform cycle which most suppresses a degree of reflection of the source radio frequency power, by using the respective source frequencies of the source radio frequency power at a plurality of second time points in the waveform cycle and an interpolated source frequency in each of a plurality of second division periods of the waveform cycle divided by the plurality of second time points, while changing the respective source frequency at the plurality of second time points based on the first temporal change pattern or a temporal change pattern of the source frequency generated from the first temporal change pattern, and
a number of the plurality of second division periods is greater than a number of the plurality of first division periods.
